(19)

**Europäisches Patentamt**
**European Patent Office**
**Office européen des brevets**

(11) **EP 4 766 052 A1**

(12) **EUROPEAN PATENT APPLICATION**

(43) Date of publication:
**24.06.2026 Bulletin 2026/26**

(21) Application number: **24307257.6**

(22) Date of filing: **20.12.2024**

(51) International Patent Classification (IPC):
**H05K 7/20** (2006.01)

(52) Cooperative Patent Classification (CPC):
**H05K 7/2079; H05K 7/20836**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **OVH**
**59100 Roubaix (FR)**

(72) Inventors:
• **CHEHADE, Ali**
**59283 Moncheaux (FR)**

• **HNAYNO, Mohamad**
**59110 La Madeleine (FR)**
• **BAUDUIN, Hadrien**
**59650 Villeneuve d'Ascq (FR)**

(74) Representative: **BCF Global**
**17-21, rue Saint-Fiacre**
**75002 Paris (FR)**

<u>Remarks:</u>
Amended claims in accordance with Rule 137(2) EPC.

(54) **DATACENTER FAN REGULATION PROCESS**

(57)      A method for controlling a speed of a fan of a dry cooling unit of a datacenter, the method comprising:
- estimating (202) a thermal load (Q) of the rack-mounted data processing assemblies (120A-120N),
- estimating (206) an air flow (AF) depending on the thermal load (Q) and an ambient temperature of the air flow ($T_{amb}$),
- estimating (208) a fan rotation speed of said at least one fan assembly (110A) depending on the estimated air flow (AF), and
- controlling (210) a voltage of said at least one fan assembly (110A) depending on the estimated fan rotation speed (nfan),
wherein the process (200) comprises a step (205) of modeling the air flow (AF) as a polynomial function of the ambient temperature.

**FIG. 2**

**Description**

**FIELD**

The present technology generally relates to the field of datacenter liquid cooling arrangements.

**BACKGROUND**

Datacenters as well as many computer processing facilities house multitudes rack-mounted electronic processing equipment. In operation, such electronic processing equipment generates a substantial amount of heat that must be dissipated in order avoid electronic component failures and ensure continued efficient processing operations.

To this end, various liquid cooling measures have been implemented to facilitate the dissipation of heat generated by the electronic processing equipment. One such measure employs liquid block cooling techniques for directly cooling one or more heat-generating processing components. This technique utilizes liquid cooling blocks having internal channels that receive cooling liquid from a cooling liquid source that are in thermal contact with the heat-generating processing components.

Depending on the access to water resources, in many cases, the preferred cooling liquid source comprises a dry cooling unit. Dry cooling units supply cooling liquid via pumps to rack-mounted electronic processing equipment as well as receive heated liquid from the electronic processing equipment and are configured to re-cool the received heated liquid for circulation back to the electronic processing equipment.

The energy consumption of datacenters is a significant issue due to several factors. Datacenters require a substantial amount of electricity to power servers and storage devices. This demand is growing rapidly, driven by an increasing use of cloud computing, big data analytics and artificial intelligence, for instance. Also, the cooling systems themselves consume a large amount of energy. The high energy consumption of datacenters contributes to greenhouse gas emissions, which have a significant impact on climate change.

Efforts to improve energy efficiency are crucial to mitigate these effects.

As such, there remains an interest in attempting to minimize the energy consumption of the cooling systems of datacenters.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

**SUMMARY**

Embodiments of the present technology have been developed based on certain drawbacks associated with conventional dry cooling techniques and implementations to improve energy efficiency.

In one aspect of the inventive concepts, the present technology relates to a liquid cooling method for a datacenter liquid cooling system for cooling rack-mounted processing assemblies, the datacenter liquid cooling system comprising a cooling arrangement provided with:

a cooling unit configured to supply a cooling liquid to the rack-mounted processing assemblies and receive a heated liquid from the rack-mounted processing assemblies,

a forward liquid distribution circuit including a temperature sensor, and/or a forward valve to convey the cooling liquid from the cooling unit to the rack-mounted processing assemblies,

a return liquid distribution circuit including a temperature sensor and/or a valve to convey the heated liquid from the rack-mounted processing assemblies back to the cooling unit and,

a control module panel communicatively-coupled to the temperature sensor, temperature sensor, to receive data therefrom,

each of the rack-mounted data processing assemblies comprising at least one heat-generating electronic processing element and at least one liquid cooling block arranged to be in respective thermal contact with the at least one heat-generating electronic processing element and fluidly-coupled to the first forward liquid distribution circuit,

the cooling unit comprising at least one fan assembly and at least one heat exchanger assembly for cooling the liquid circulating in the system and entering the cooling unit by the return liquid distribution circuit by a flow of air,

the method comprises a step of

- estimating a thermal load (Q) of the rack-mounted data processing assemblies,
- estimating an air flow (AF) depending on the thermal load (Q) and an ambient temperature of the air flow ($T_{amb}$),
- estimating a fan rotation speed of said at least one fan assembly depending on the estimated air flow (AF), and
- controlling a voltage of said at least one fan assembly depending on the estimated fan rotation speed (nfan),

wherein the process comprises a step of modeling the air flow (AF) as a polynomial function of the ambient temperature.

The fan controlling method of the present technology ensures energy consumption reduction as well as better water cooling.

In some embodiments, the polynomial function is a six-degree polynomial:

$$AF(\Delta T, Q, T) = a_6 T_{amb}^6 + a_5 T_{amb}^5 + a_4 T_{amb}^4 + a_3 T_{amb}^3 + a_2 T_{amb}^2 + a_1 T_{amb} + a_0$$

In some embodiments, coefficient $a_6$ is comprised between $10^{-6}$ and $5 * 10^{-4}$ $m^3/(h°C^6)$.

In some embodiments, coefficient $a_5$ is comprised between $10^{-5}$ and $6 * 10^{-3} m^3 / (h°C^5)$.

In some embodiments, coefficient $a_4$ is comprised between $-2 * 10^{-3}$ and $2 * 10^{-2}$ $m^3/(h°C^4)$.

In some embodiments, coefficient $a_3$ is comprised between $-5 * 10^{-1}$ and $0.5$ $m^3/(h°C^3)$.

In some embodiments, coefficient $a_2$ is comprised between 1 and 50 $m^3/(/h°C^2)$.

In some embodiments, coefficient $a_1$ is advantageously comprised between 1 and 600 $m^3/(h°C)$.

In some embodiments, coefficient $a_0$ is advantageously comprised between 1000 and 30000 $m^3/h$.

In some embodiments, the method comprises a step of modeling the rotation speed of the fan of the at least one fan assembly as a second-degree polynomial of the air flow.

In some embodiments, the method comprises a step of comparing an electrical power calculated with the estimated fan speed and a real electrical power of the fan of the at least one fan assembly.

In some embodiments, the method comprises a step of sampling the estimated thermal load (Q).

In some embodiments, the method comprises a step of sampling the difference of temperature between a temperature of the liquid entering the cooling unit and a temperature of the liquid exiting the cooling unit.

The present technology also relates to a system configured to implement the method as already described.

The present technology also relates to a computer program comprising instructions which, when the program is executed by a computer, cause the computer to carry out the steps of the method as already described.

The present technology also relates to a computer-readable medium comprising instructions which, when executed by a computer, cause the computer to carry out the steps of the method as already described.

In the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task at hand.

In the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.), USB keys, flash memory cards, solid state-drives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

## BRIEF DESCRIPTION OF THE DRAWINGS

For a better understanding of the present technology, as well as other aspects and further features thereof, reference is made to the following description which is to be used in conjunction with the accompanying drawings, where:

FIG. 1 illustrates a high-level functional block diagram of a datacenter liquid cooling system comprising a liquid arrangement, in accordance with the nonlimiting embodiments of the present technology;

FIG. 2 illustrates a flow diagram of a fan regulation process of fans of the system of FIG. 1, in accordance with the nonlimiting embodiments of the present technology; and

FIG. 6 illustrates a high-level functional block diagram of a controller for the liquid cooling system of FIG. 1.

It should be appreciated that, unless otherwise explicitly specified herein, the drawings are not to scale.

## DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative circuitry embodying the principles of the present technology. Similarly, it will be appreciated that any flowcharts, flow diagrams, state transition diagrams, pseudo-code, and the like represent various processes that may be substantially represented in non-transitory computer-readable media and so executed by a computer or processor, whether or not such computer or processor is explicitly shown.

The functions of the various elements shown in the FIGs. including any functional block labeled as a "processor", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. In some embodiments of the present technology, the processor may be a general-purpose processor, such as a central processing unit (CPU) or a processor dedicated to a specific purpose, such as a digital signal processor (DSP). Moreover, explicit use of the term a "processor" should not be construed to refer exclusively to hardware capable of executing software, and may implicitly include, without limitation, application specific integrated circuit (ASIC), field programmable gate array (FPGA), read-only memory (ROM) for storing software, random access memory (RAM), and non-volatile storage. Other hardware, conventional and/or custom, may also be included.

Software modules, or simply modules which are implied to be software, may be represented herein as any combination of flowchart elements or other elements indicating performance of process steps and/or textual description. Such modules may be executed by hardware that is expressly or implicitly shown. Moreover, it should be understood that module may include for example, but without being limitative, computer program logic, computer program instructions, software, stack, firmware, hardware circuitry or a combination thereof which provides the required capabilities.

Equally noteworthy, while various operations of the inventive concepts may be represented by flowchart elements arranged in certain sequential order, it should be understood that these steps may be combined, sub-divided, re-ordered, or changed to operate concurrently without departing from the teachings of the present technology. In fact, at least some of the processing steps may be executed in parallel or in series. Accordingly, the ordering, sequencing, and grouping of the processing steps is not a limitation of the present technology.

Given this fundamental understanding, the disclosed embodiments are directed to a system and method configured to minimize the damaging effects due to crucial flow component failures of a single liquid cooling arrangement by sharing liquid cooling components/resources of other liquid cooling arrangements.

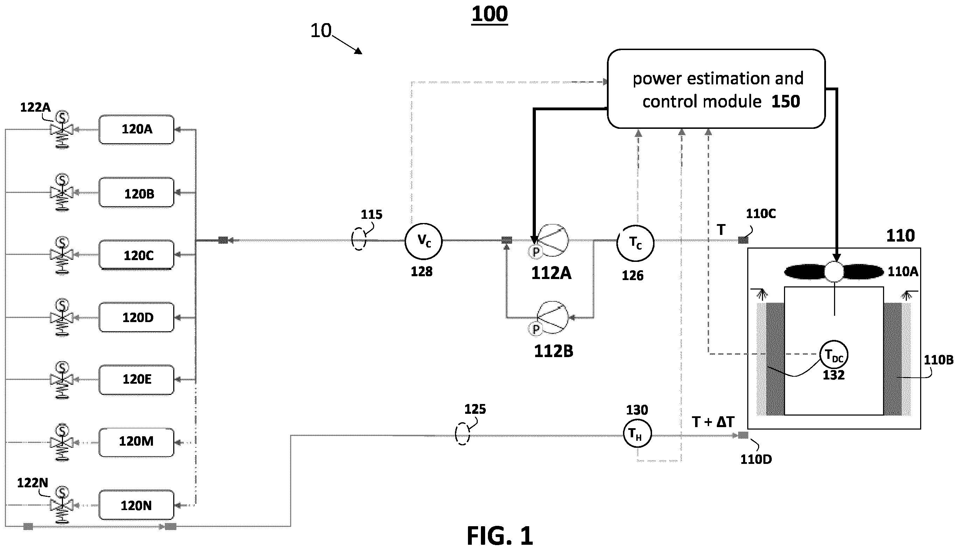

FIG. 1 illustrates a high-level functional block diagram of a datacenter liquid cooling system **10** comprising a liquid cooling arrangement **100** for cooling corresponding rack-mounted processing assemblies, in accordance with the nonlimiting embodiments of the present technology.

As shown, the liquid cooling arrangement **100** of system **10** includes a dry cooling unit **110,** a plurality of rack-mounted processing assemblies **120A-120N,** a plurality of smart valves **122A-122N** in which each smart valve is fluidly-coupled to a respective processing assembly, a forward liquid distribution circuit **115** incorporating at least one pump **112A** for supplying cooling liquid from the dry cooling unit **110** (two pumps on **112A, 112B** on FIG. 1), a return liquid distribution circuit **125** for returning heated liquid back to the dry cooling unit **110** and, optionally, a control module panel **150** communicatively coupled to various components and sensors.

The dry cooling unit **110** may be located on any suitable stable support surface, such as, for example, the roof of a datacenter/computer processing facility building. The dry cooling unit **110** serves to dissipate thermal energy from a heated liquid circulating therethrough to the ambient environment. For example, in a datacenter or similar facility, the dry cooling unit **110** operates to receive heated liquid from the respective rack-mounted processing assemblies **120A-120N** and extracts the thermal energy from the heated liquid by dissipating the energy into the ambient environment via the respective at least one fan assembly **110A** to thereby re-cool the heated liquid. The dry cooling unit **110** then operates to supply the re-cooled liquid back to the respective rack-mounted processing assemblies **120A-120N.**

As shown, the dry cooling unit **110** includes at least one heat exchanger **110B** and at least one fan assembly **110A.** The heat exchanger **110B** may manifest a variety of configurations, such as, air-to-liquid heat exchanger *etc.,* a chiller, or cooling tower or a plate heat exchange, and may further include evaporative cooling pads. For purposes of the instant disclosure, the exact configuration of the dry cooling unit **110** and heat exchanger **110B** is not limiting, as various configurations could be employed without departing from the concepts of the instant disclosure.

As also shown, the forward liquid distribution circuit **115** incorporates at least one pump **112A.**

Optionally, the forward liquid distribution circuit **115** also incorporates a forward "smart" control valve **119A.** For purposes of the instant disclosure, the term "smart" valve refers to a valve that is pressure-independent, temperature-responsive, incorporates a differential pressure regulator to automatically adjust to system pressure changes as well as shut down given certain operational conditions. Such smart valves may comprise PICVs, ABQMs, other functionally similar valves, or combinations of valves, such as a solenoid valve combined with a control valve. In this implementation, the smart control valve **119A** is configured to sense and adjust the flow of the cooling/re-cooled liquid supplied to the processing assemblies **120A-120N.** Advantageously, the forward smart control valves **119A** are also communicatively coupled to the control module panel to provide notification about the liquid flow.

The heated liquid from the rack-mounted processing assemblies **120A-120N** is returned back to the dry cooling unit **110** for re-cooling via the respective return liquid distribution circuit **125.**

As depicted, the dry cooling unit **110** supplies the cooling/re-cooled liquid to the rack-mounted processing assemblies **120A-120N** at a nominal temperature T and the heated liquid returned to the dry cooling unit **110** is at a nominal temperature $T + \Delta T$, where $\Delta T$ represents the temperature differential between the cooling/re-cooled liquid and the heated liquid.

The liquid cooling arrangement **100** of system **10** includes a plurality of rack-mounted processing assemblies **120A-120N** which receive the supplied cooling/re-cooled liquid via the corresponding forward liquid distribution circuit **115** to internally channel the cooling liquid to the heat-generating processing components (*e.g.,* water circulated through water blocks), and convey the heated liquid from the heat-generating processing components to the return liquid distribution circuit **125.**

The rack-mounted processing assemblies **120A-120N** may or may not be configured with similar heat-generating processing components. As such, each of the rack-mounted processing assemblies **120A-120N** may have different temperature and flow rate requirements for proper operations.

It will be appreciated that, while the rack-mounted processing assemblies **120A-120N** are depicted to be arranged in a parallel configuration, it is not meant to be limiting, as the processing assemblies **120A-120N** may also be arranged in a serial or combined parallel and serial configuration without departing from the concepts of the instant disclosure.

Each of the rack-mounted processing assemblies **120A-120N** can be fluidly-coupled to a smart valve **122A-122N** that dynamically controls the flow rate of the corresponding processing assembly **120A-120N** based on detected liquid temperatures.

Along the forward liquid distribution circuit **115,** liquid cooling arrangement **100** also incorporates temperature sensor **126** for measuring the temperature of the supplied cooling liquid Tc, flow pressure sensor **127** for measuring the pressure of the flow of the supplied liquid P, and a volume sensor **128** for measuring the flow rate of the supplied cooling liquid Vc.

For the return liquid distribution circuit **125,** liquid cooling arrangement **100** also incorporates temperature sensor **125** for measuring the temperature of the return heated liquid $T_H$.

As will be described in detail below, another parameter of interest are the "pinch" values of the heat exchanger assembly **110B.** That is, each heat exchanger assembly **110B** has a "hot side" and a "cold side". For the hot side, the pinch value $\Delta$Thotpinch is defined as the difference between the temperature of the hot air exiting the heat exchanger and the temperature of the hot liquid entering the heat exchanger. And, for the cold side, the pinch value $\Delta$Tcoldpinch is defined as the difference between the temperature of the fresh air entering the heat exchanger and the temperature of cold liquid exiting the heat exchanger. Both of the pinch values $\Delta$Thotpinch, $\Delta$Tcoldpinch are positive numbers. The pinch value of the cold side is noted Pinch from now on.

Each of the measured Tc, Vc, $T_H$, and $T_{DC}$ ($T_{DC}$ = $T_{amb}$ after the cooling pad, if there is) values are then supplied to the control panel **150.** As will be described in detail below, based on these measured values, module **150** functions to determine the estimated power consumed by the rack-mounted processing assemblies **120A-120N** and dynamically controls a rotational speed of dry cooling unit fan assembly **110A** to improve cooling system efficiency.

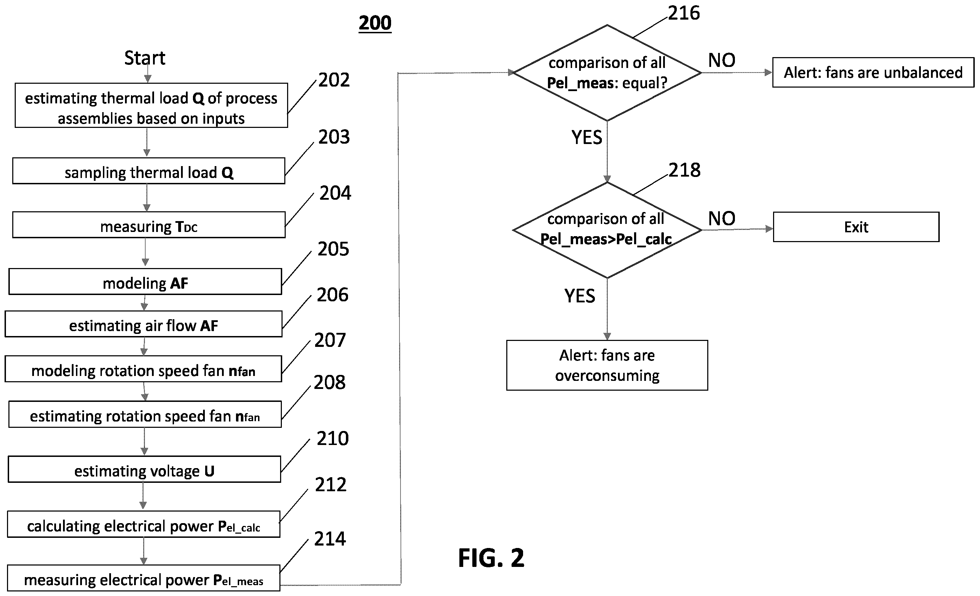

With this said, FIG. 2 illustrates a flow diagram of fan control process **200** of a liquid cooling system for rack-mounted processing assemblies, in accordance with the non-limiting embodiments of the present technology. The power estimation and fan control process **200** may be executed by control module **150.** The execution of module **150** may be performed by a controller **600.**

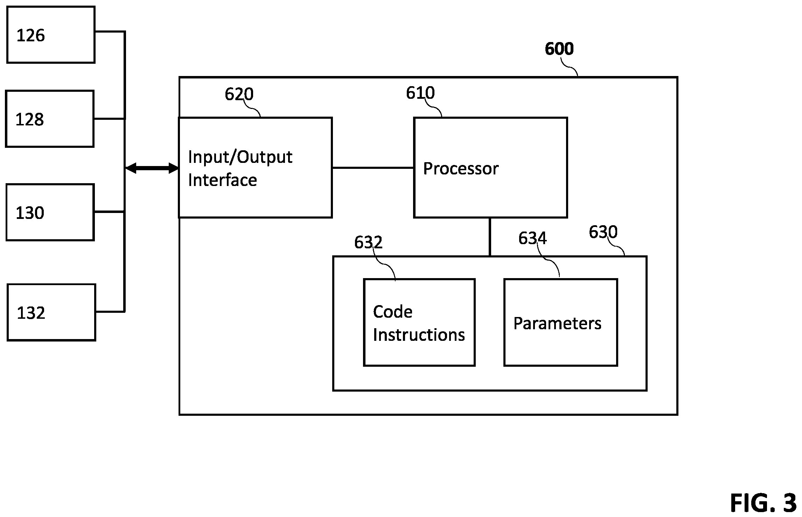

For example, such a controller is depicted by the high-level functional block diagram of FIG. 3. As shown, the controller **600** comprises a processor or a plurality of cooperating processors (represented as a processor **610** for simplicity), a memory device or a plurality of memory devices (represented as a memory device **630** for simplicity), and an input/output interface **620** (or separate input and output interfaces) allowing the controller **600** to communicate with certain components of the liquid cooling arrangement **100.** The processor **610** is operatively connected to the memory device **630** and to the input/output interface **620.** The memory device **630** includes a storage for storing parameters **634,** including for example and without limitation the above-mentioned pre-determined conductivity thresholds. The memory device **630** may comprise a non-transitory computer-readable medium for storing code instructions **632** that are executable by the processor **610** to allow the controller **600** to perform the various tasks allocated to the controller **600.**

The controller **600** is operatively connected, via the input/output interface **620,** to the components of liquid cooling arrangement **100,** such as, the temperature sensor **126** that measures the temperature of cooling liquid Tc, the temperature sensor **132** that measures the temperature of ambient dry cooling unit temperature $T_{DC}$, the temperature sensor **130** that measures the temperature of heated liquid $T_H$, and the volume sensor **128** that measures the cooling liquid flow rate Vc, The controller **600** executes the code instructions **632** stored in the memory device **630** to implement the various above-described functions of the control module **150.**

However, it will be appreciated that in other embodiments, power estimation and fan control process **200** or portions thereof may be executed by relevant components, such as, for example, temperature sensors, volume sensors, and pumps, etc. For purposes of the instant disclosure, the exact entity or entities executing process **200** is not limiting with regard to the inventive concepts herein presented.

Returning back to FIG. 2, process **200** commences at step **202,** in which the thermal load Q of the forward liquid distribution circuit **115** is estimated. The thermal load Q of the forward liquid distribution circuit **115** corresponds to the power consumed by the rack-mounted processing assemblies **120A-120N.** As such, process **200** determines $\Delta$T representative of the temperature differential between the supplied cooling liquid temperature, as measured by Tc, and the returning heated liquid temperature, as measured by $T_H$. Process **200** then computes the estimated thermal load Q of the forward liquid distribution circuit **115** based on the relationship: thermal load $Q = m \cdot cp \cdot \Delta T$, where $m$ represents the mass flow rate of water and $cp$ represents the specific heat calculated as a function of the fluid average temperature.

In some embodiments, process **200** then moves to step **203** to discretizing the estimated thermal load Q by sampling the thermal load Q on subsequent regular ranges, the sampled thermal load being the maximal value on each range. For instance, the load ranks can increase each 50kW, from 50kW to 800kW. In this case, if the estimated thermal load is 425 kW, the sampled estimated thermal load is 450kW. Alternatively, the load ranks can increase each 25kW.

In some embodiments, the method also comprises a step of sampling the difference $\Delta$T.

Process **200** then moves to step **204** to evaluate the measured ambient temperature of the dry cooling unit **110** $T_{DC}$, which depends on whether evaporative cooling pads are employed. Advantageously, the ambient temperature is considered to be comprised between - 30°C and 22°C.

Then, as will be detailed, process **200** evaluates the dry cooling unit fan assembly **110A** operating parameters. Such operating parameters may include, but are not limited to, fan speed $n_{fan}$ (in rotations per minute: rpm), fan piloting voltage U (approximately between 0-10V), fan efficiency parameter $\eta$ (in %), and estimated fan power consumption Peleccalc. It will be appreciated that these operating parameters may be influenced by prevailing conditions, such as, for example, thermal load Q, ambient dry cooling unit temperature $T_{DC}$, outdoor humidity, and other factors, like altitude.

At step **206,** the air flow AF is determined by the values of the ambient temperature, the $\Delta$T and the sampled thermal load Q. Process **200** advantageously comprises a preliminary step **205** of expressing the air flow as a polynomial function of the ambient temperature. The coefficients of each power of ambient temperature depends at least on the $\Delta$T and

the sampled thermal load.

For instance, the air flow is a 6-degree polynomial of the ambient temperature:

$$AF(\Delta\mathrm{T}, \mathrm{Q}, \mathrm{T}) = a_6 T_{amb}^6 + a_5 T_{amb}^5 + a_4 T_{amb}^4 + a_3 T_{amb}^3 + a_2 T_{amb}^2 + a_1 T_{amb} + a_0.$$

where all the coefficients $a_n$ are computed based on the set of values $(\Delta\mathrm{T}, \mathrm{Q})$.

Coefficient $a_6$ is advantageously comprised between $10^{-6}$ and $5*10^{-4}$ $m^3/(h°C^6)$, for instance comprised between $10^{-5}$ and $5*10^{-5}$ $m^3/(h°C^6)$.

Coefficient $a_5$ is advantageously comprised between $10^{-5}$ and $6*10^{-3}$ $m^3/(h°C^5)$, for instance comprised between $10^{-5}$ and $10^{-3}$ $m^3/(h°C^5)$.

Coefficient $a_4$ is advantageously comprised between $-2*10^{-3}$ and $2*10^{-2}$ $m^3/(h°C^4)$, for instance comprised between $10^{-3}$ and $10^{-2}$ $m^3/(h°C^4)$.

Coefficient $a_3$ is advantageously comprised between $-5*10^{-1}$ and $0.5$ $m^3/(h°C^3)$.

Coefficient $a_2$ is advantageously comprised between 1 and 50 $m^3/(h°C^2)$, for instance comprised between 1 and 20 $m^3/(h°C^2)$.

Coefficient $a_1$ is advantageously comprised between 1 and 600 $m^3/(h°C)$, for instance comprised between 50 and 550 $m^3/(h°C)$.

The coefficient $a_0$ is advantageously comprised between 1000 and 30000 $m^3/h$, for instance comprised between 4000 and 25000 $m^3/h$.

Then, at step **208**, process **200** evaluates the fan speed $n_{fan}$ (in rotations per minute: rpm) depending on the air flow AF and the configuration of the fan.

Advantageously, process **200** comprises a preliminary step **207** of determining the fan speed as a function of the air flow AF for the configuration of the fan, that depends on the pressure drop in the dry cooling unit, and particularly on the pressure drop induced by the specific heat exchanger assembly **110B** of the dry cooling unit, as well as on the efficiency parameter $\eta$.

For instance, per each heat exchanger, the fan speed $n_{fan}$ is a 2-degree polynomial of the air flow AF:

$$n_{fan} = b_2 AF^2 + b_1 AF + b_0$$

The fan speed $n_{fan}$ is comprised between 0 and 1000 RPM, for instance between 0 and 980 RPM.

The fan speed $n_{fan}$ is comprised between 0 and $n_{max}$, for instance between 0 and 980 RPM.

Coefficient $b_2$ is advantageously comprised between $10^{-11}$ and $10^{-9}$ $RPM.\,(h/m^3)^2$.

Coefficient $b_1$ is advantageously comprised between $10^{-5}$ and $10^{-3}$ $RPM.\,h/m^3$.

Coefficient $b_0$ is advantageously comprised between $10^{-1}$ and $10^2$ $RPM$.

Parameter $\eta$ is comprised between 0 and 100%.

Process **200** comprises a step **210** of calculating the voltage to be applied to the fan. The voltage U is proportional to the fan speed $n_{fan}$. For instance, U is chosen to be comprised between 0V and 10V, such that it can be expressed as:

$$U = \frac{n_{fan}}{n_{max}} * 10$$

The maximal fan speed $n_{max}$ can be 1000 RPM.

Then, at step **212**, an electrical power Pel_calc is calculated as a function of the fan speed $n_{fan}$.

At step **214**, process **200** comprises measuring the real electrical power Pel_meas of the fan assembly **110A**. If the system **10** comprises more than one fan, at step **216**, process **200** checks if all the fans have an electrical power that are equal with a given tolerance ($\pm10\%$ for instance, or $\pm20\%$ for instance). If they do not, process **200** issues an alert that the fans are unbalanced or overconsuming. If they do, then, at step **218**, there is a comparison between the calculated electrical power Pel_calc and the measured electrical power Pel_meas. If the measured electrical power Pel_meas is lower than the calculated electrical power, process **200** exits. If the measured electrical power is higher than the calculated electrical power, an alert is issued that the fans are overconsuming.

Process **200** is advantageously repeated at a regular frequency, each 30 minutes for example, each 3 minutes for example, or could be an average of a laps of time.

An example is now given, with a thermal load estimated at step **202** to 366kW and $\Delta\mathrm{T}$=18K. At step **203** the estimated thermal load Q is sampled to 375kW, considering increase ranks of 25kW. At step **206**, the air flow is determined by the values of the ambient temperature, the temperature differential $\Delta\mathrm{T}$ and the sampled thermal load Q, as is shown in FIG. 3. In this example, the air flow is a 6-degree polynomial of the ambient temperature:

$$AF(\Delta T, Q, T) = a_6 T_{amb}^6 + a_5 T_{amb}^5 + a_4 T_{amb}^4 + a_3 T_{amb}^3 + a_2 T_{amb}^2 + a_1 T_{amb}^1 + a_0 \quad ,$$

where all the coefficients $a_n$ are computed based on the set of values $(\Delta T, Q)$.

Advantageously, coefficients an come from the complete design and characterization process, as all the thermal and operating points of the dry cooling unit **110** have been predicted and/or measured, feeding a database, the sampling step easing the way to link the operation with the model and find the right coefficients each time process **200** is executed and query the database.

The ambient temperature being measured at 21°C gives an air flow value of AF(18, 300, 21)=41968 $m^3/h$. Then, at step **208**, process **200** evaluates the fan speed n$_{fan}$ (in rotations per minute: rpm) depending on the air flow AF and the configuration of the fan, with a static pressure increase of 78,11 Pa and an efficiency parameter $\eta$ of 71,4%. The fan speed is estimated to $n_{fan}$=762 RPM and a voltage of 7,8V. The associated electrical power Pel_calc equals 1003,3W.

Process **200** comprises a sub-process **400** of anticipating the evolution of the voltage control.

Sub-process **400** aims at smoothing the voltage U that is being applied to the fan assembly **110A** instead of working either to 0V or a maximal value, like, for instance, 9V or 10V.

Sub-process **400** comprises a step **402** of determining an air temperature, called triggering temperature, or actuation temperature, such that the voltage triggers on the triggering temperature before the set temperature T$_i$ and a voltage minimum is to be communicated with the fans at the triggering temperature. The triggering temperature of Tc, referenced to as T$_{i-min}$, can be expressed as

$$T_{i-min} = T_i - M,$$

where M is a margin.

At step **404**, sub-process **400** comprises determining the set point T$_i$ depending on the ambient temperature T$_{amb}$ and the sampled thermal load Q.

Advantageously, the set point of Tc is chosen as follows:

- If the ambient temperature is lower than or equal to a threshold temperature, for instance 22°C, and the sampled thermal load Q is lower than or equal to a threshold thermal load, for example 500kW, then the set point is a lower set point T$_{iL}$, for example 25°C,
  This configuration takes advantage of the cold ambient air that can cool quite easily the liquid entering the dry cooling since the thermal load is rather low;
- If the ambient temperature is lower than or equal to a threshold temperature, for instance 22°C, and the sampled thermal load Q is higher than the threshold thermal load, for example 500kW, then the set point is a higher set point T$_{iH}$, for example 27°C,
  This configuration takes advantage of the cold ambient air but the thermal load being higher (compared to the previously described configuration), the set point is chosen higher;
- If the ambient temperature is higher than the threshold temperature, for instance 22°C, and the sampled thermal load Q is lower than or equal to the threshold thermal load, for example 500kW, then the set point is chosen as

  $T_i = T_{amb} + P_{inch}^L$, where $P_{inch}^L$ is for instance of 3K,

  This configuration takes into account the not so fresh air and the low thermal load;
- If the ambient temperature is higher than the threshold temperature, for instance 22°C, and the sampled thermal load Q is higher than the threshold thermal load, for example 500kW, then the set point is chosen as $T_i = T_{amb} + P_{inch}^H$,

  where $P_{inch}^H$ is for instance of 5K;

This configuration takes into account the not so fresh air and the high thermal load.

In some embodiments, the margin M is a constant. In some embodiments, the margin M is function of $U_{max}$ (in percentage). For instance, M is a linear function of $U_{max}$. For instance, $M = c * U_{max} + d$, where c and d are coefficients.

The margin M is a value to calculate the set point for fans kick ON; so it is in °C.

Coefficient c can depend on the amplitude of the fan voltage and coefficient d can depend on coefficient c. For example $c = \frac{V_{max} - V_{min}}{A_{\%max} - A_{\%min}}$, and $d = V_{max} - c * A_{\%max}$,

where $A_{\%max}$ is the maximal percentage of the voltage that can be applied to the fans and $A_{\%min}$ is the minimal percentage of the voltage that can be applied to the fans. For instance, V$_{min}$ is comprised between 0V and 2V, V$_{max}$ is comprised between 9 and 10V, A$_{\%min}$ is comprised between 5 and 15% and A$_{\%max}$ is comprised between 90 and 100%.

While the above-described implementations have been described and shown with reference to particular steps performed in a particular order, it will be understood that these steps may be combined, sub-divided, or re-ordered without departing from the teachings of the present technology. At least some of the steps may be executed in parallel or in series. Accordingly, the order and grouping of the steps is not a limitation of the present technology.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A liquid cooling method (50) for a datacenter liquid cooling system (10) for cooling rack-mounted processing assemblies (120A-120N, 220A-220N), the datacenter liquid cooling system comprising a cooling arrangement (100) provided with:

   a cooling unit (110) configured to supply a cooling liquid to the rack-mounted processing assemblies (120A-120N) and receive a heated liquid from the rack-mounted processing assemblies (120A-120N),
   a forward liquid distribution circuit (115) including a temperature sensor (126), to convey the cooling liquid from the cooling unit to the rack-mounted processing assemblies (120A-120N),
   a return liquid distribution circuit (125) a temperature sensor (130) to convey the heated liquid from the rack-mounted processing assemblies (120A-120N) back to the cooling unit (110),
   a control module panel (150) communicatively-coupled to the temperature sensor (126), temperature sensor (130), to receive data therefrom,
   each of the rack-mounted data processing assemblies (120A-120N) comprising at least one heat-generating electronic processing element and at least one liquid cooling block arranged to be in respective thermal contact with the at least one heat-generating electronic processing element and fluidly-coupled to the forward liquid distribution circuit (115),
   the cooling unit (110) comprising at least one fan assembly (110A) and at least one heat exchanger assembly (110B) for cooling the liquid circulating in the system (10) and entering the cooling unit (110) by the return liquid distribution circuit (125) by a flow of air,

   the method comprises a step of

   - estimating (202) a thermal load (Q) of the rack-mounted data processing assemblies (120A-120N),
   - estimating (206) an air flow (AF) depending on the thermal load (Q) and an ambient temperature of the air flow ($T_{amb}$),
   - estimating (208) a fan rotation speed of said at least one fan assembly (110A) depending on the estimated air flow (AF), and
   - controlling (210) a voltage of said at least one fan assembly (110A) depending on the estimated fan rotation speed (nfan),

   wherein the process (200) comprises a step (205) of modeling the air flow (AF) as a polynomial function of the ambient temperature.

2. The method of claim 1, wherein the polynomial function is a six-degree polynomial:

$$AF(\Delta T, Q, T) = a_6 T_{amb}^6 + a_5 T_{amb}^5 + a_4 T_{amb}^4 + a_3 T_{amb}^3 + a_2 T_{amb}^2 + a_1 T_{amb} + a_0$$

3. The method of the preceding claim, wherein coefficient $a_6$ is comprised between $10^{-6}$ and $5*10^{-4}$ $m^3/(h°C^6)$.

4. The method of claim 2 or 3, wherein coefficient $a_5$ is comprised between $10^{-5}$ and $6 * 10^{-3} m^3/(h°C^5)$.

5. The method of any claims 2 to 4, wherein coefficient $a_4$ is comprised between $-2 * 10^{-3}$ and $2 * 10^{-2}$ $m^3/(h°C^4)$.

6. The method of any claims 2 to 5, wherein coefficient $a_3$ is comprised between $-5 * 10^{-1}$ and $0.5$ $m^3/(h°C^3)$.

7. The method of any claims 2 to 6, wherein coefficient $a_2$ is comprised between 1 and 50 $m^3/(h°C^2)$.

8. The method of any claims 2 to 7, wherein coefficient $a_1$ is advantageously comprised between 1 and 600 $m^3/(h°C)$.

9. The method of any claims 2 to 8, wherein coefficient $a_0$ is advantageously comprised between 1000 and 30000 $m^3/h$.

10. The method of any of the preceding claims, comprising a step (207) of modeling the rotation speed of the fan of the at least one fan assembly as a second-degree polynomial of the air flow.

11. The method of any of the preceding claims, comprising a step (218) of comparing an electrical power calculated with the estimated fan speed and a real electrical power of the fan of the at least one fan assembly.

12. The method of any of the preceding claims, comprising a step (203) of sampling the estimated thermal load (Q).

13. The method of any of the preceding claims, comprising a step of sampling the difference of temperature between a temperature of the liquid entering the cooling unit and a temperature of the liquid exiting the cooling unit.

14. A system configured to implement the method of any of the preceding claims.

15. A computer program comprising instructions which, when the program is executed by a computer, cause the computer to carry out the steps of the method of any of claims 1 to 13.

16. A computer-readable medium comprising instructions which, when executed by a computer, cause the computer to carry out the steps of the method of any of claims 1 to 13.

**Amended claims in accordance with Rule 137(2) EPC.**

1. A liquid cooling method (50) for a datacenter liquid cooling system (10) for cooling rack-mounted processing assemblies (120A-120N, 220A-220N), the datacenter liquid cooling system comprising a cooling arrangement (100) provided with:

> a cooling unit (110) configured to supply a cooling liquid to the rack-mounted processing assemblies (120A-120N) and receive a heated liquid from the rack-mounted processing assemblies (120A-120N),
> a forward liquid distribution circuit (115) including a temperature sensor (126), to convey the cooling liquid from the cooling unit to the rack-mounted processing assemblies (120A-120N),
> a return liquid distribution circuit (125) a temperature sensor (130) to convey the heated liquid from the rack-mounted processing assemblies (120A-120N) back to the cooling unit (110),
> a control module panel (150) communicatively-coupled to the temperature sensor (126), temperature sensor (130), to receive data therefrom,
> each of the rack-mounted data processing assemblies (120A-120N) comprising at least one heat-generating electronic processing element and at least one liquid cooling block arranged to be in respective thermal contact with the at least one heat-generating electronic processing element and fluidly-coupled to the forward liquid distribution circuit (115),
> the cooling unit (110) comprising at least one fan assembly (110A) and at least one heat exchanger assembly (110B) for cooling the liquid circulating in the system (10) and entering the cooling unit (110) by the return liquid distribution circuit (125) by a flow of air,

> **characterized in that** the method comprises a step of

>> - estimating (202) a thermal load (Q) of the rack-mounted data processing assemblies (120A-120N),
>> - estimating (206) an air flow (AF) depending on the thermal load (Q) and an ambient temperature of the air flow ($T_{amb}$),
>> - estimating (208) a fan rotation speed of said at least one fan assembly (110A) depending on the estimated air flow (AF), and
>> - controlling (210) a voltage of said at least one fan assembly (110A) depending on the estimated fan rotation speed (nfan),

> wherein the process (200) comprises a step (205) of modeling the air flow (AF) as a polynomial function of the ambient temperature.

2. The method of claim 1, wherein the polynomial function is a six-degree polynomial:

$$AF(\Delta\mathrm{T}, \mathrm{Q}, \mathrm{T}) = a_6 T_{amb}^6 + a_5 T_{amb}^5 + a_4 T_{amb}^4 + a_3 T_{amb}^3 + a_2 T_{amb}^2 + a_1 T_{amb} + a_0$$

3. The method of the preceding claim, wherein coefficient $a_6$ is comprised between $10^{-6}$ and $5*10^{-4}$ $m^3/(h°C^6)$.

4. The method of claim 2 or 3, wherein coefficient $a_5$ is comprised between $10^{-5}$ and $6 * 10^{-3} m^3/(h°C^5)$.

5. The method of any claims 2 to 4, wherein coefficient $a_4$ is comprised between $-2 * 10^{-3}$ and $2 * 10^{-2}$ $m^3/(h°C^4)$.

6. The method of any claims 2 to 5, wherein coefficient $a_3$ is comprised between $-5 * 10^{-1}$ and $0.5$ $m^3/(h°C^3)$.

7. The method of any claims 2 to 6, wherein coefficient $a_2$ is comprised between 1 and 50 $m^3/(h°C^2)$.

8. The method of any claims 2 to 7, wherein coefficient $a_1$ is advantageously comprised between 1 and 600 $m^3/(h°C)$.

9. The method of any claims 2 to 8, wherein coefficient $a_0$ is advantageously comprised between 1000 and 30000 $m^3/h$.

10. The method of any of the preceding claims, comprising a step (207) of modeling the rotation speed of the fan of the at least one fan assembly as a second-degree polynomial of the air flow.

11. The method of any of the preceding claims, comprising a step (218) of comparing an electrical power calculated with the estimated fan speed and a real electrical power of the fan of the at least one fan assembly.

12. The method of any of the preceding claims, comprising a step (203) of sampling the estimated thermal load (Q).

13. The method of any of the preceding claims, comprising a step of sampling the difference of temperature between a temperature of the liquid entering the cooling unit and a temperature of the liquid exiting the cooling unit.

14. A liquid cooling method (50) A datacenter liquid cooling system (10) for cooling rack-mounted processing assemblies (120A-120N, 220A-220N), the datacenter liquid cooling system comprising a cooling arrangement (100) provided with:

   a cooling unit (110) configured to supply a cooling liquid to the rack-mounted processing assemblies (120A-120N) and receive a heated liquid from the rack-mounted processing assemblies (120A-120N),
   a forward liquid distribution circuit (115) including a temperature sensor (126), to convey the cooling liquid from the cooling unit to the rack-mounted processing assemblies (120A-120N),
   a return liquid distribution circuit (125) a temperature sensor (130) to convey the heated liquid from the rack-mounted processing assemblies (120A-120N) back to the cooling unit (110),
   a control module panel (150) communicatively-coupled to the temperature sensor (126), temperature sensor (130), to receive data therefrom,
   each of the rack-mounted data processing assemblies (120A-120N) comprising at least one heat-generating electronic processing element and at least one liquid cooling block arranged to be in respective thermal contact with the at least one heat-generating electronic processing element and fluidly-coupled to the forward liquid distribution circuit (115),
   the cooling unit (110) comprising at least one fan assembly (110A) and at least one heat exchanger assembly (110B) for cooling the liquid circulating in the system (10) and entering the cooling unit (110) by the return liquid distribution circuit (125) by a flow of air,
   the system further comprising a processor (610) for implementing the steps of the method of any of claims 1 to 13.

15. A computer program comprising instructions which, when the program is executed by a computer, cause the computer to carry out the steps of the method of any of claims 1 to 13.

16. A computer-readable medium comprising instructions which, when executed by a computer, cause the computer to carry out the steps of the method of any of claims 1 to 13.

FIG. 1

EP 4 766 052 A1

**200**

**FIG. 2**

EP 4 766 052 A1

FIG. 3

Europäisches
Patentamt
European
Patent Office
Office européen
des brevets

# EUROPEAN SEARCH REPORT

**Application Number**

EP 24 30 7257

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2022/201902 A1 (SHAW MARK EDWARD [US] ET AL) 23 June 2022 (2022-06-23) * paragraphs [0022], [0027] - [0035], [0038], [0040], [0046] - [0048]; figures 1-2c,4a,4b * ----- | 1-16 | INV. H05K7/20 |
| A | US 2009/268404 A1 (CHU RICHARD C [US] ET AL) 29 October 2009 (2009-10-29) * paragraphs [0033] - [0036], [0043], [0047], [0048]; figures 3,7A,7B * ----- | 1-16 | |

**TECHNICAL FIELDS SEARCHED (IPC)**

H05K

The present search report has been drawn up for all claims

| Place of search | Date of completion of the search | Examiner |
|---|---|---|
| The Hague | 5 June 2025 | Schneider, Florian |

EPO FORM 1503 03.82 (P04C01)

## ANNEX TO THE EUROPEAN SEARCH REPORT
## ON EUROPEAN PATENT APPLICATION NO.

EP 24 30 7257

This annex lists the patent family members relating to the patent documents cited in the above-mentioned European search report.
The members are as contained in the European Patent Office EDP file on
The European Patent Office is in no way liable for these particulars which are merely given for the purpose of information.

05-06-2025

| Patent document cited in search report | Publication date | Patent family member(s) | Publication date |
|---|---|---|---|
| US 2022201902 A1 | 23-06-2022 | US 2022201902 A1<br>US 2024357775 A1 | 23-06-2022<br>24-10-2024 |
| US 2009268404 A1 | 29-10-2009 | NONE | |

EPO FORM P0459

For more details about this annex : see Official Journal of the European Patent Office, No. 12/82